# FASCICULE DE BREVET EUROPEEN

(11) **EP 4 528 180 B1**
(45) Date de publication et mention de la délivrance du brevet: **22.04.2026**
(21) Numéro de dépôt: 24192494.3
(22) Date de dépôt: 02.08.2024
(51) Int. Cl.: F25B 9/00, F17C 13/00, F25B 9/10, F25D 19/00

(54) **DISPOSITIF ET PROCÉDÉ DE RÉFRIGÉRATION**
KÜHLVORRICHTUNG UND -VERFAHREN
REFRIGERATION DEVICE AND METHOD

(30) Priorité: 22.09.2023 FR 2310050
(43) Date de publication de la demande: 26.03.2025
(73) Titulaire: L'AIR LIQUIDE, SOCIETE ANONYME POUR L'ETUDE ET L'EXPLOITATION DES PROCEDES GEORGES CLAUDE, 75007 Paris (FR)
(72) Inventeur: Martin, Florian, 38360 SASSENAGE (FR); Szmigiel, Mathieu, 38360 SASSENAGE (FR); Butterworth, James, 38360 SASSENAGE (FR)
(74) Mandataire: Air Liquide

(56) Documents cités:
- FR-A1- 3 129 198
- JP-A- 2008 241 215
- US-A1- 2022 221 108

## Description

L'invention concerne un dispositif et un procédé de réfrigération.

L'invention concerne plus particulièrement un dispositif de réfrigération cryogénique comprenant une enceinte délimitant un volume étanche sous vide refermé par un couvercle, le dispositif comprenant au moins un refroidisseur cryogénique monté au travers du couvercle et ayant une première portion située à l'extérieur de l'enceinte et une seconde portion située dans l'enceinte, le refroidisseur cryogénique étant du type utilisant une source froide de fluide de cycle cryogénique tel que de l'hélium, le dispositif comprenant au moins un plateau conducteur thermique destiné à recevoir et refroidir un composant, par exemple un ensemble de câble(s), le au moins un plateau étant refroidi par un flux de fluide de cycle via un circuit de fluide de cycle alimentant un ensemble d'échangeur(s) de chaleur en échange thermique respectivement avec le plateau.

L'invention concerne un dispositif de réfrigération permettant de refroidir des éléments à une température cryogénique inférieure à 100K et notamment inférieure à 50K et/ou inférieure à 4K.

En particulier, l'invention concerne les dispositifs de réfrigération qui permettent de refroidir à des températures très basses, de l'ordre du millikelvin (« réfrigération subKelvin »). Ces températures très basses sont classiquement obtenues via un réfrigérateur à dilution ou un refroidisseur cryogénique de type Joule Thomson à He4 ou à He3.

Dans ces dispositifs, il est nécessaire d'apporter une puissance froide jusqu'à une température de par exemple 4K à un ou plusieurs étages de réfrigération. Une installation de ce type doit pouvoir être refroidie rapidement lors de sa mise en marche. De plus, la surface expérimentale disponible pour les échantillons ou câbles à refroidir doit être optimisée.

Les réfrigérateurs à dilution ont besoin d'un apport de puissance froide à une température inférieure à 4K pour fonctionner. Cette puissance froide est fournie généralement à partir de tubes à gaz pulsé (réfrigérateurs à dilution « secs »), soit via un bain d'hélium liquide (réfrigérateurs à dilution « humides »). Un refroidissement d'³He ou d'un un mélange ³He-4He est généralement nécessaire pour une utilisation à des températures inférieures à 1K.

Cependant les tubes pulsés ont une puissance unitaire limitée, il faut un nombre conséquent, plusieurs dizaines, de pulse tubes pour obtenir des puissances suffisantes aux besoins actuels et futurs. Ce nombre de tubes à gaz pulsé limite la surface expérimentale disponible pour refroidir des équipements et des échantillons. Il faut également refroidir de l'³He ou un mélange ³He-4He pour une utilisation à des températures inférieures à 2K. De plus, le temps de mise en froid avec ce type de technologies est relativement important. Ainsi, cette solution ne permet cependant pas de fournir une puissance froide très importante au niveau des échantillons à refroidir et génère en outre des vibrations.

De plus, l'augmentation de la puissance à extraire peut être freinée par les résistances thermiques de contact des plateaux. Pour les réfrigérateurs à dilution de grandes puissances, un des besoins critiques est de pré-refroidir plusieurs milliers de câbles ou échantillons. Cette puissance froide peut être installée dans la partie centrale du plateau pour refroidir les échantillons ou câbles au bord du plateau. L'augmentation des distances entre un point froid ponctuel qui apporte la puissance froide (tube à gaz pulsé) et l'échantillon à refroidir fait face à des résistances thermiques significatives (conduction dans le plateau de grande taille et résistances de contact intermédiaires). Ceci est une raison de la perte d'efficacité thermique. Ainsi, l'augmentation de la puissance ne permet pas forcément un refroidissement efficace.

JP 2008 241215 A divulgue un dispositif de réfrigération cryogénique selon le préambule de la revendication 1.

Un but de la présente invention est de pallier tout ou partie des inconvénients de l'art antérieur relevés ci-dessus.

A cette fin, le dispositif selon l'invention, par ailleurs conforme à la définition générique qu'en donne le préambule ci-dessus, est essentiellement caractérisé en ce que le circuit de fluide de cycle possède une conduite d'amenée de fluide de cycle d'abord vers un collecteur monté sur le plateau, le circuit de fluide de cycle possédant au moins une conduite de transfert configurée pour transférer du fluide de cycle du collecteur vers au moins un échangeur de chaleur monté sur le même plateau, le circuit de fluide de cycle possédant au moins une conduite de renvoi configurée pour renvoyer du fluide ayant circulé dans le au moins un échangeur de chaleur vers le collecteur. Un dispositif de réfrigération cryogénique selon la présente invention est défini dans la revendication 1.

Par ailleurs, des modes de réalisation de l'invention peuvent comporter l'une ou plusieurs des caractéristiques suivantes :
- le dispositif comprend plusieurs échangeurs de chaleur montés sur le même plateau et des conduites de transfert respectives pour transférer du fluide de cycle du collecteur vers les échangeurs de chaleur, les échangeurs de chaleur du même plateau étant alimentés en fluide de cycle en parallèle à partir de la conduite d'amenée via le collecteur,
- la conduite d'amenée de fluide traverse le couvercle au niveau d'une plaque support refermant de façon étanche un passage au travers du couvercle, la plaque support, le collecteur et la conduite d'amenée étant reliés mécaniquement les uns aux autres en formant une entité physique qui peut être montée/démontée relativement à l'enceinte, par exemple relativement au couvercle,
- le circuit de fluide de cycle possède une conduite de retour reliant le collecteur à une partie du réfrigérateur et configurée pour renvoyer le fluide de cycle réchauffé ayant circulé dans tout ou partie de l'ensemble d'échangeur(s) de chaleur,
- la conduite de retour traverse le couvercle au niveau de la plaque support et également reliée à cette dernière et au collecteur,
- le collecteur est un échangeur de chaleur en échange thermique avec le plateau et possède un circuit interne de de circulation du fluide de cycle en vue de transférer de la puissance froide au plateau,
- le ou les échangeurs de chaleur comprennent ou sont constitués de l'un au moins parmi : une plaque montée sur ou dans un logement du plateau, la plaque possédant un circuit interne de circulation du fluide de cycle en vue de transférer de la puissance froide au plateau, une conduite de circulation du fluide de cycle noyée et serpentant dans l'épaisseur du plateau,
- le ou les échangeurs de chaleur sont reliés au collecteur via un ensemble de raccords fluidiques démontables, par exemple au moins au niveau d'une extrémité de la conduite de transfert et/ou de la conduite de renvoi,
- le dispositif comporte plusieurs plateaux disposés selon une direction de répartition dans l'enceinte et destinés à être refroidis à des températures respectives déterminées, au moins deux plateaux comportent chacun un collecteur et au moins un échangeur de chaleur reliée au collecteur via une conduite de transfert,
- les collecteurs d'au moins deux plateaux distincts sont alimentés en fluide de cycle par des conduites d'amenée respectives,
- le collecteur d'un premier plateau est alimenté en fluide de cycle par une conduite d'amenée de fluide, le collecteur et/ou le(s) échangeur(s) de chaleur d'un second plateau étant alimenté(s) en fluide de cycle ayant circulé dans au moins un échangeur et/ou collecteur du premier plateau via un ensemble de conduite de liaison,
- au moins une partie des échangeurs de chaleur est muni d'au moins un parmi : un capteur de température de l'échangeur, un organe de chauffage configuré pour réguler la température de l'échangeur de chaleur,
- le circuit de fluide de cycle comprend une ou plusieurs vanne(s) pilotable(s), par exemple au niveau d'au moins une conduite d'amenée de fluide et configurée(s) pour réguler le débit de fluide de cycle, par exemple en fonction d'une consigne et/ou d'une mesure d'un capteurs de température,
- moins une partie des échangeurs de chaleur et/ou collecteur sont logés dans des logements respectifs correspondants formés dans les plateaux respectifs, une bordure périphérique des échangeurs de chaleur et/ou collecteur étant en contact avec une bordure conjuguée des échangeurs de chaleur respectifs délimitant le logement,
- au moins une partie de l'ensemble d'échangeurs de chaleur et/ou collecteur sont montés dans les logements respectifs des plateaux en étant insérés dans lesdits logements avec déplacement transversal et/ou parallèle relativement au plans des plateaux.

L'invention concerne également un procédé de réfrigération tel que défini dans la revendication 16 utilisant un dispositif selon l'une quelconque des caractéristiques ci-dessus ou ci-dessous, comprenant une étape de stockage et/ou de production d'un fluide de cycle cryogénique liquide au niveau du réfrigérateur, une étape de mise en circulation dudit fluide cryogénique dans l'enceinte vers le au moins un collecteur et du collecteur vers le au moins un échangeur de chaleur pour refroidir au moins au plateau, le procédé comprenant une étape de revoir du fluide de cycle réchauffé ayant circulé dans au moins un échangeur de chaleur vers une portion du réfrigérateur en vue de son refroidissement pour recommencer un cycle de circulation dans l'enceinte.

L'invention peut concerner également tout dispositif ou procédé alternatif comprenant toute combinaison des caractéristiques ci-dessus ou ci-dessous dans le cadre des revendications.

D'autres particularités et avantages apparaîtront à la lecture de la description ci-après, faite en référence aux figures dans lesquelles :

### Brève description des figures

L'invention sera mieux comprise à la lecture de la description qui va suivre donnée uniquement à titre d'exemple et faite en se référant aux dessins annexés dans lesquels :
[Fig. 1] est une vue schématique et partielle, en coupe verticale, illustrant un premier exemple de réalisation d'une installation de réfrigération selon l'invention,
[Fig. 2] est une vue schématique et partielle, en coupe verticale, illustrant un deuxième exemple de réalisation d'une installation de réfrigération selon l'invention,
[Fig. 3] est une vue schématique et partielle, en coupe verticale, illustrant un troisième exemple de réalisation d'une installation de réfrigération selon l'invention,
[Fig. 4] est une vue schématique et partielle, en coupe verticale, illustrant un quatrième exemple de réalisation d'une installation de réfrigération selon l'invention,
[Fig. 5] est une vue schématique et partielle, en coupe verticale, illustrant un cinquième exemple de réalisation d'une installation de réfrigération selon l'invention,
[Fig. 6] est une vue schématique et partielle, en perspective, illustrant un premier mode de réalisation possible du premier exemple de réalisation,
[Fig. 7] est une vue schématique et en transparence partielle, de dessous, du détail de la [Fig. 6],
[Fig. 8] est une vue schématique et partielle, en perspective, illustrant un deuxième mode de réalisation possible du premier exemple de réalisation,
[Fig. 9] est une vue schématique et en transparence partielle, de dessous, du détail de la [Fig. 8],
[Fig. 10] est une vue schématique et partielle, en coupe verticale, illustrant un détail d'un sixième exemple de réalisation d'une installation de réfrigération selon l'invention,
[Fig. 11] est une vue schématique et partielle, en coupe verticale, illustrant un détail d'un septième exemple de réalisation d'une installation de réfrigération selon l'invention,
[Fig. 12] est une vue schématique et partielle, en coupe verticale, illustrant un détail d'un exemple de réalisation d'un échangeur de chaleur de type à bain pompé pouvant être utilisé dans l'installation de réfrigération selon l'invention,
[Fig. 13] est une vue schématique et partielle, en coupe horizontale de l'échangeur de chaleur de la [Fig. 12],
[Fig. 14] est une vue schématique et partielle, en coupe verticale, illustrant un détail d'un autre exemple de réalisation d'un échangeur de chaleur pouvant être utilisé dans l'installation de réfrigération selon l'invention.

### Description détaillée

Sur toutes les figures, les mêmes références se rapportent aux mêmes éléments.

Dans cette description détaillée, les réalisations suivantes sont des exemples. Bien que la description se réfère à un ou plusieurs modes de réalisation, cela ne signifie pas que les caractéristiques s'appliquent seulement à un seul mode de réalisation. De simples caractéristiques de différents modes de réalisation peuvent également être combinées et/ou interchangées pour fournir d'autres réalisations.

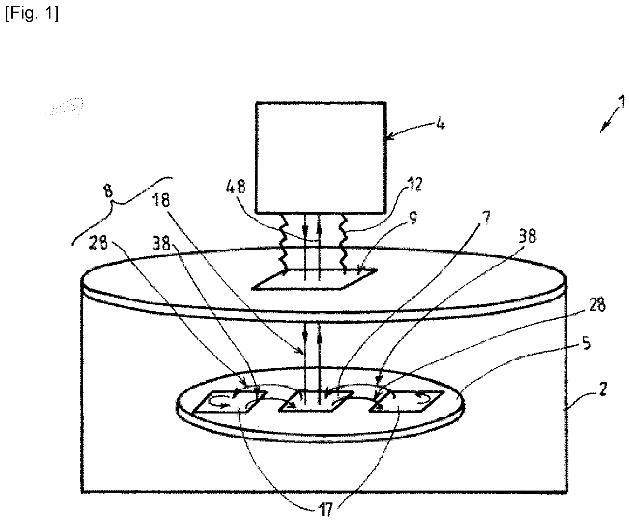

L'installation 1 de réfrigération cryogénique illustrée à la [Fig. 1] comprend une enceinte 2 délimitant un volume refermé par un couvercle 3, par exemple en inox ou aluminium. De préférence, le volume est sous vide et abrite au moins un plateau 5 (un seul dans cet exemple) conducteur thermique et formant un étage thermique. Comme décrit ci-après, plusieurs plateaux peuvent être prévus pour former des étages thermiques à des températures respectives qui peuvent être décroissantes selon une direction de répartition (par exemple verticalement du haut vers le bas).

Un faisceau de câbles à refroidir (non représenté) peut être monté sur un ensemble plaque(s) support montée(s) sur le au moins un plateau 5. C'est-à-dire que des câbles peuvent s'étendre dans l'enceinte 2 et en échange thermique avec le ou les plateaux.

D'autres composants peuvent être refroidis au niveau du ou des plateaux 5. Le dispositif peut ainsi comprendre à cet effet un ensemble de passages formés au travers du couvercle 3 et du ou des plateaux pour le passage de câble(s) et/ou d'appareillage(s) dans l'enceinte 2.

Le au moins un plateau 5 est refroidi par un refroidisseur ou réfrigérateur 4 cryogénique à une température déterminée.

Le refroidisseur 4 cryogénique peut être monté au travers du couvercle 3 avec une première portion située à l'extérieur de l'enceinte 2 et une seconde portion située dans l'enceinte 2.

Le refroidisseur 4 cryogénique comprend de préférence un fluide de cycle cryogénique (par exemple à base d'hélium) et un circuit 8 de fluide de cycle assurant une circulation et une mise en échange thermique du fluide de cycle au niveau d'au moins un plateau 5.

L'ensemble de plateaux est refroidi par un flux de fluide de cycle via le circuit 8 de fluide de cycle alimentant un ensemble d'échangeur(s) de chaleur 17 en échange thermique respectivement avec le plateau 5.

C'est-à-dire que, au lieu de refroidir le ou les plateaux 5, 6 par conduction uniquement par des tubes à gaz pulsé par exemple ou un bain d'hélium, le dispositif 1 prévoit de transférer la puissance froide via un flux de fluide de cycle.

De préférence, le fluide de cycle contient ou est constitué d'hélium. Le fluide de cycle peut être refroidi dans un état supercritique ou superfluide par exemple à une température inférieure à 4K ou inférieure à 2K avant d'être mis en échange thermique avec le ou les plateaux 5, 6. Ceci permet de distribuer très efficacement la puissance froide à l'endroit où elle est nécessaire.

Comme mentionné et illustré, le refroidisseur 4 cryogénique peut être monté au travers du couvercle 3 et peut posséder une première extrémité ou portion située à l'extérieur de l'enceinte 2 et une seconde extrémité ou portion située dans l'enceinte 2. Le refroidisseur 4 est configuré pour fournir du froid au niveau de sa seconde portion.

Le refroidisseur 4 est par exemple du type utilisant une source froide de fluide de cycle liquéfié tel que de l'hélium ou de l'azote. La puissance froide du réfrigérateur est stockée et/ou produite au niveau de sa première extrémité et cette puissance froide est transférée vers les plateaux 5, 6 via un flux du fluide de cycle transférant de la puissance froide de la première extrémité vers la seconde extrémité du refroidisseur. Après échange thermique avec la ou les plateaux 5, 6 le fluide de cycle est renvoyé vers une partie chaude du refroidisseur 4 pour recommencer le cycle (compression, détente...).

Le refroidisseur 4 comprend par exemple un circuit de cycle configuré pour soumettre le fluide de cycle à un cycle thermodynamique amenant le fluide de cycle à au moins une extrémité froide du circuit de cycle à une température cryogénique déterminée via une détente du fluide de cycle comprimé. Le circuit de fluide de cycle comportant par exemple un mécanisme de compression du fluide de cycle (compresseur(s)), au moins un organe de refroidissement du fluide de cycle (échangeur(s) de chaleur), un mécanisme de détente du fluide de cycle (vanne(s) et/ou turbine(s)) et au moins un organe de réchauffage (échangeur(s) de chaleur) du fluide de cycle détendu. Le réchauffage et le refroidissement peut être assuré en partie au moins par un ou des échangeur(s) de chaleur à contre-courant pour refroidir et réchauffer simultanément deux parties du circuit de cycle.

Le refroidisseur 4 cryogénique utilise par exemple un fluide de cycle comprenant au moins l'un parmi : de l'hélium, de l'hydrogène, de l'azote, de l'argon du néon. Le dispositif 1 comprend un circuit 8 avec un ensemble de conduite(s) d'amenée 18 d'au moins une partie du fluide de cycle froid vers le ou les plateaux 5, 6 à refroidir.

Comme visible à la [Fig. 1], le circuit 8 de fluide de cycle possède une conduite 18 d'amenée de fluide de cycle d'abord vers un collecteur 7 monté sur le plateau 5. Le circuit 8 de fluide de cycle possède également une conduite 28 de transfert configurée pour transférer du fluide de cycle du collecteur 7 vers au moins un échangeur de chaleur 17 monté sur le même plateau 5 (deux échangeurs 17 de chaleur dans cette exemple).

Le circuit 8 de fluide de cycle possède au moins une conduite 38 de renvoi configurée pour renvoyer du fluide ayant circulé dans le au moins un échangeur 17 de chaleur vers le collecteur 7.

Cette architecture permet de transférer le fluide de cycle froid à un collecteur porté par le plateau 5 et de distribuer cette puissance froide vers un ou plusieurs échangeurs 7 de chaleur du plateau 5.

Ceci permet une distribution de puissance froide de manière efficace et homogène sur de grandes surfaces à partir d'un nombre réduit de conduite 18 d'amenée (une seule notamment). Dans le cas (tel qu'illustré à la [Fig. 1]) où plusieurs échangeurs 17 de chaleur sont montés sur le même plateau 5, des conduites 28 de transfert respectives peuvent être prévues pour transférer du fluide de cycle du collecteur 7 vers les échangeurs de chaleur 17. Dans ce cas, les échangeurs de chaleur 17 du même plateau 5 peuvent être alimentés en fluide de cycle en parallèle à partir de la conduite 18 d'amenée via le collecteur 7.

Après avoir circulé dans les échangeurs 17 de chaleur, le fluide de cycle relativement plus chaud peut être renvoyé dans le collecteur 7 via des conduites 38 de renvoi respectives. Puis ce fluide de cycle chaud peut être renvoyé dans le réfrigérateur 4 via une conduite 48 de retour en vue par exemple d'être à nouveau refroidi et de recommencer un cycle.

A noter que la conduite 18 d'amenée (ou les conduites 18 d'amenée car il peut y en avoir plusieurs) et la conduite 48 de retour (ou les conduites 48 de retour car il peut y en avoir plusieurs) sont de préférence contenues dans une gaine 12 ou ligne isolée thermiquement sous vide pour éviter les entrées thermiques. La gaine 12 peut en particulier être prévue entre le couvercle 3 et la portion extérieure du réfrigérateur 4.

La conduite 18 d'amenée de fluide (et la conduite 48 de retour) peuvent traverser le couvercle 3 au niveau d'une plaque 9 ou bride support refermant de façon étanche un passage au travers du couvercle 3.

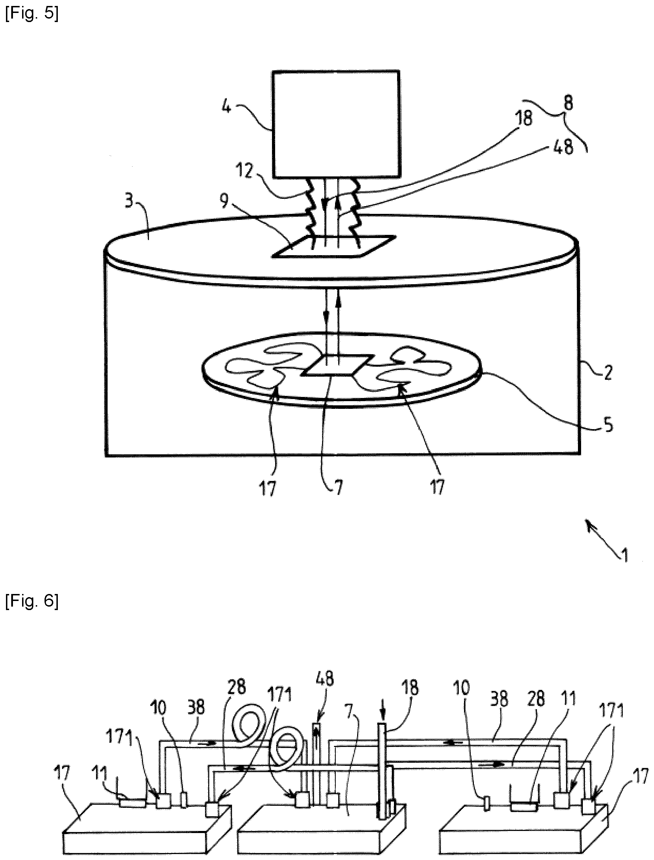

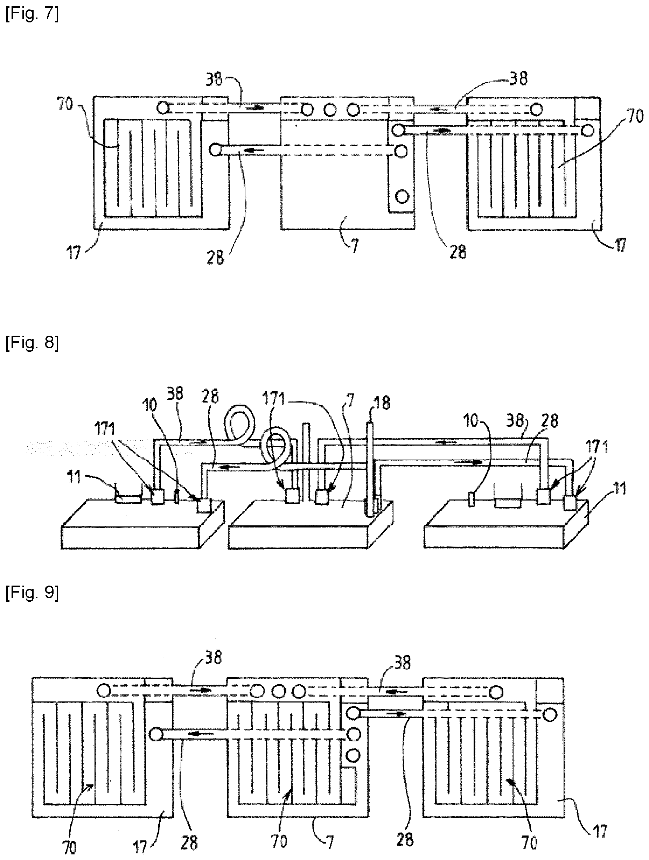

La plaque 9 support, le collecteur 7 et les conduites 18 d'amenée et 48 de retour peuvent être reliés mécaniquement les uns aux autres en formant une entité physique qui peut être montée/démontée relativement 2 à l'enceinte 2, par exemple verticalement relativement au couvercle 3. Par exemple, un outillage tel qu'un guide ou tuteur vertical peut être utilisé pour soutenir cet ensemble lors des montages/démontages relativement à l'enceinte et aux plateaux. Les [Fig. 6] et [Fig. 7] illustre un exemple de structure de collecteur 7 associé à deux échangeurs de chaleur 17 qui reçoit le fluide de cycle froid (via la conduite 18 d'amenée) et le distribue aussitôt aux échangeurs 17 de chaleur via des conduites 28 de transfert. De plus le collecteur 7 reçoit les flux de fluide de cycle ayant circulé dans les échangeurs 17 de chaleur via des conduites 38 de renvoi et peut renvoyer ce fluide de cycle relativement plus chaud, par exemple dans la conduite 48 de retour. C'est-à-à-dire que, dans cet exemple, contrairement aux échangeurs 17 de chaleur, le collecteur 7 n'est pas configuré pour assurer un échange de chaleur optimisé avec le plateau qui le porte. Par exemple, les échangeurs 17 de chaleur comportent un circuit 70 interne de circulation du fluide de cycle qui serpente pour optimiser l'échange de chaleur avec la plateau 5. Le collecteur 7 peut être dépourvu d'un tel circuit interne comme illustré.

En revanche, et comme illustré dans la variante des [Fig. 8] et [Fig. 9], le collecteur 7 peut également être un échangeur de chaleur en échange thermique avec le plateau 5 (configuré pour cela), par exemple en possédant un circuit 70 interne de de circulation du fluide de cycle en vue de transférer de la puissance froide au plateau 5.

Comme illustré, les échangeurs de chaleur 17 peuvent être reliés au collecteur 7 via un ensemble de raccords 171 fluidiques démontables. Par exemple, au moins une des extrémités de la conduite 28 de transfert et/ou de la conduite 38 de renvoi peut être munie d'un tel raccord 171 permettant le montage/démontage aisé par rapport au collecteur/échangeur. Ceci permet en particulier de raccorder aisément les échangeurs 17 au collecteur 7 après montage ou avant démontage de l'ensemble collecteur(s) 7 et conduites 18, 48 tel que décrit précédemment.

Alternativement ou en combinaison, une partie de l'ensemble de conduites du circuit 8 de fluide de cycle assurant la circulation du fluide de cycle vers ou depuis les échangeurs de chaleur 7, 17 et/ou collecteurs 7 peuvent être soudés et/ou brasés sur les échangeurs 7, 17 de chaleur ou collecteurs 7.

Au moins une partie de ces conduites du circuit 8 de fluide de cycle assurant la circulation du fluide de cycle vers ou depuis les échangeurs de chaleur 7, 17 et/ou depuis ou vers le(s) collecteur(s) 7 peuvent être configurées pour présenter une flexibilité déterminée, par exemple une portion coudée, permettant d'absorber les variations de dimensions dues aux variations de températures entre la température ambiante à l'arrêt et une température cryogénique de fonctionnement du dispositif 1.

Dans les exemples précités, les échangeurs de chaleur 17 comprennent ou sont constitués d'une plaque montée sur ou dans un logement du plateau 5 et possédant un circuit 70 interne de circulation du fluide de cycle en vue de transférer de la puissance froide au plateau 5.

Les [Fig. 6] et [Fig. 8], illustrent en outre schématiquement le fait qu'au moins une partie des échangeurs de chaleur 17 peut être muni d'un capteur 10 de mesure de la température de l'échangeur et/ou d'un organe 11 de chauffage configuré pour réguler la température de l'échangeur 17 de chaleur. Par exemple chaque échangeur 17 de chaleur possède un tel capteur 10 et/ou un organe 11 de réchauffage.

De même, le ou les organes 11 de réchauffage peuvent permettre d'assurer ce contrôle de température.

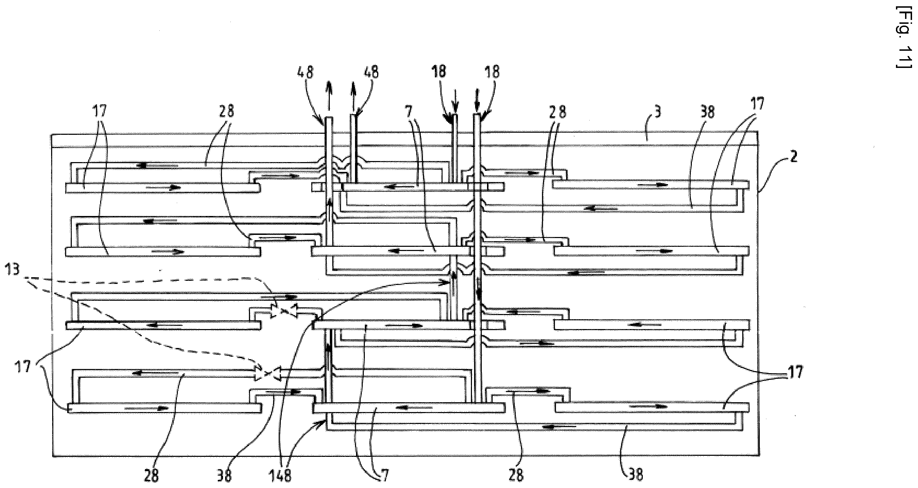

Ainsi, le dispositif 1 peut comprendre une ou plusieurs vanne(s) 13 pilotable(s) dans le circuit 8 de fluide de cycle, par exemple au niveau d'au moins une conduite 38 d'amenée de fluide et configurée(s) pour réguler le débit de fluide de cycle, par exemple en fonction d'une consigne et d'une mesure du ou des capteurs 10 de température (cf. [Fig. 11]).

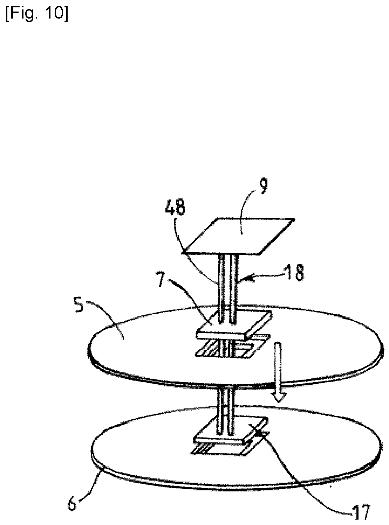

Au moins une partie des échangeurs de chaleur 17 et/ou collecteur 7 peuvent être logés dans des logements respectifs correspondants formés dans les plateaux 5, 6 respectifs. Par exemple, une bordure périphérique des échangeurs de chaleur 17 et/ou collecteur 7 est en contact avec une bordure conjuguée des échangeurs de chaleur 17 respectifs délimitant le logement (cf. [Fig. 10]).

Au moins une partie de l'ensemble d'échangeurs de chaleur 17 et/ou collecteur 7 peuvent être montés dans les logements respectifs des plateaux en étant insérés dans lesdits logements avec déplacement transversal aux plans des plateaux 5, 6 (cf. montage vertical [Fig. 10]).

Bien entendu, ces logements peuvent déboucher sur le bord du plateau pour permettre un montage/démontage des échangeurs de chaleur 17 et/ou collecteurs 7 selon une direction parallèle au plan du plateau.

Cependant, cette forme de réalisation n'est nullement limitative. Ainsi, par exemple, au moins un des échangeurs 17 de chaleur peut être une simple conduite de circulation du fluide de cycle noyée et serpentant dans l'épaisseur du plateau 5 (cf. [Fig. 5]). Dans ce cas, le capteur 11 de température éventuel peut mesurer la température au niveau du plateau par exemple.

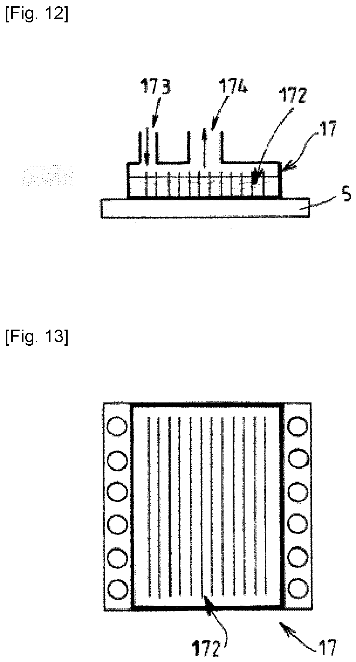

De même, en variante ou en combinaison, au moins un échangeur 7 de chaleur peut comprendre un système de bain pompé comme illustré aux [Fig. 12] et [Fig. 13]. C'est-à-dire que l'échangeur 17 de chaleur comprend un volume interne muni d'ailettes 172 et destiné à recevoir un volume de fluide de cycle via au moins une entrée 173 et une sortie 174 prévue pour permettre une circulation de ce fluide. L'échangeur 171 de chaleur est par exemple posé sur un plateau 5 ou une plaque elle-même sur le plateau 5.

A noter également que sur l'un au moins des échangeurs 17 de chaleur peut être un ensemble de plusieurs échangeurs en série sur le plateau. C'est-à-dire que qu'une conduite 28 de transfert peut alimenter un premier échangeur 17 de chaleur qui lui-même alimente ensuite au moins un autre échangeur 17 de chaleur en série.

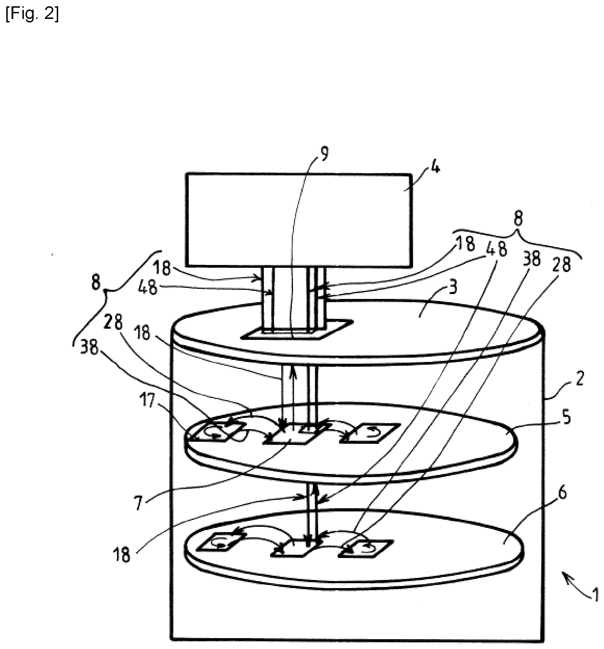

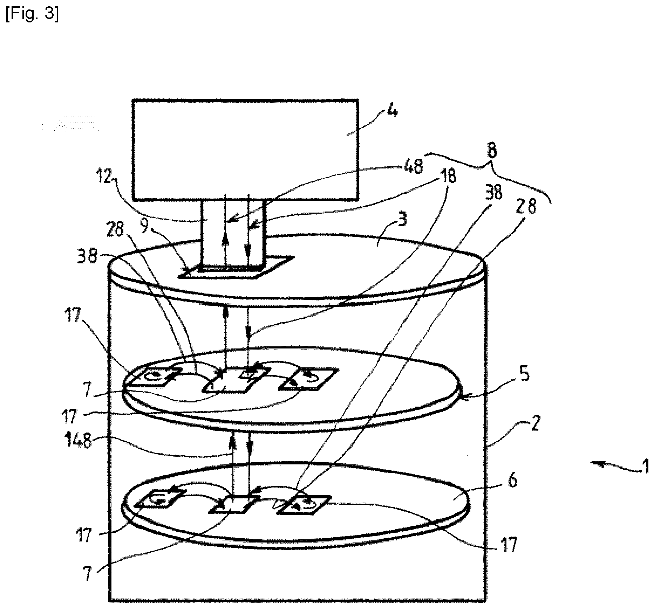

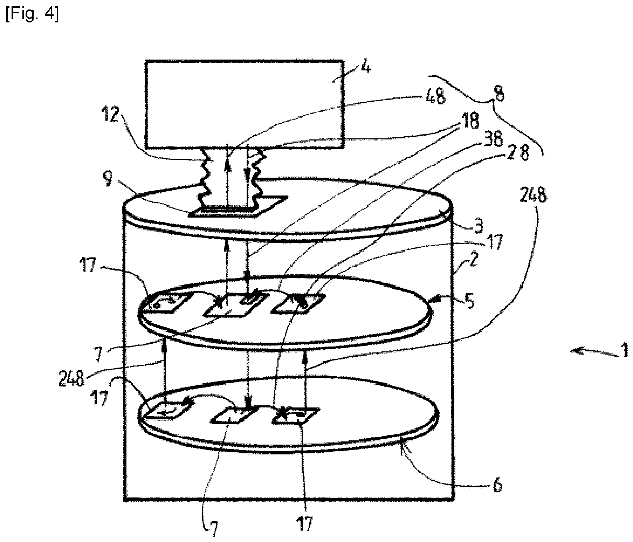

Comme illustré aux [Fig. 2], [Fig. 3] et [Fig. 4], le dispositif 1 peut comporter plusieurs plateaux 5, 6 (deux dans cet exemple) disposés selon une direction de répartition dans l'enceinte 2, par exemple verticale. Les plateaux 5, 6 sont destinés à être refroidis à des températures respectives déterminées, par exemple décroissantes vers le bas de l'enceinte 2.

Chacun des plateaux 5, 6 comporte un collecteur 7 et deux échangeurs 17 de chaleur 17 reliés au collecteur 7 via des conduites 28 de transfert et de renvoi 38 comme décrit ci-dessus.

Dans le mode de réalisation de la [Fig. 2], les collecteurs 7 des deux plateaux 5, 6 sont reliés au refroidisseur cryogénique par des conduites 18 d'amenée respectives et des conduites 48 respectifs distinctes. C'est-à-dire que les deux collecteurs 7 et plateaux respectifs sont alimentés par des flux de fluide de cycle distincts à des températures respectives qui peuvent être différentes. Ces deux flux peuvent être deux flux distincts d'un même circuit de réfrigérateur et/ou des flux appartenant à deux refroidisseurs distincts. Comme illustré, les conduite 18 d'amenée et conduite 48 de retour du plateau 6 le plus inférieur peuvent passer au travers ou via le collecteur 7 du plateau précédent (supérieur). De même, les collecteurs 7 des deux plateaux (ou plus le cas échéant) peuvent être solidaires pour pouvoir être montés ou retirés ensemble de l'enceinte 2, par exemple verticalement.

Dans le mode de réalisation de la [Fig. 3], le premier collecteur 7 d'un premier plateau 6 inférieur est relié au refroidisseur cryogénique par une conduite 18 d'amenée (au travers du collecteur 7 du second plateau supérieur). Le premier collecteur 7 alimente les échangeurs 17 de chaleur du premier plateau via des conduites 28 de transfert respectives et récupère le fluide de cycle qui a circulé dans les échangeurs 17 de chaleur de ce premier plateau 6 puis dirige ce fluide vers le second collecteur 7 du second plateau supérieur 5. Ce second collecteur 7 alimente les échangeurs de chaleur 17 du second plateau 5 (conduites de transfert) et récupère le fluide de cycle (conduites 38 de renvoi) avant de le renvoyer vers le refroidisseur (conduite 48 de retour).

Le mode de réalisation de la [Fig. 4] se distingue de celui de la [Fig. 3] uniquement en ce que le fluide de cycle qui a circulé dans les échangeurs 17 de chaleur du premier plateau 6 est envoyé ensuite directement respectivement dans les échangeurs 17 de chaleur du premier plateau (via des conduites 248 de liaison sans passer par le collecteur 7 du second plateau 5).

C'est-à-dire que dans ces deux modes de réalisation, le collecteur 7 ou les échangeurs de chaleur 17 d'un second plateau 5 sont alimentés en fluide de cycle relativement plus chaud ayant déjà circulé dans au moins un échangeur 17 de chaleur et/ou collecteur d'un premier plateau 6 (relativement plus froid). Un même flux fluide de cycle est donc utilisé pour refroidir en série deux plateaux 5, 6.

Ainsi, ceci permet d'amener du fluide de cycle d'abord vers un premier ensemble d'échangeurs de chaleur 17 destiné à être refroidi à une première température puis pour transférer du fluide de cycle ayant circulé dans le premier ensemble d'échangeurs de chaleur 17 vers un second ensemble d'échangeurs de chaleur 7 destiné à être refroidi à une seconde température supérieure à la première température.

Ainsi, deux collecteurs 7 et plateaux 5, 6 distincts peuvent être refroidis à des températures respectives qui peuvent être différentes via un même flux de fluide de cycle.

Ceci peut bien sûr être décliné pour plus de deux plateaux.

Le fluide de cycle circulant dans la conduite 18 d'amenée et/ou dans la conduite de retour 48 est sous forme liquide, gazeuse ou supercritique, l'état du fluide dans la conduite 18 d'amenée peut être différent de l'état dans la conduite 48 de retour.

Tout comme pour les collecteurs 7 de plusieurs plateaux, les échangeurs de chaleur 17 d'un même plateau ou de plateaux distincts peuvent le cas échéant être reliés mécaniquement les uns aux autres par un ensemble de conduites du circuit 8 de fluide de cycle assurant la circulation du fluide de cycle vers ou depuis les échangeurs de chaleur. Ceci permet de monter l'ensemble dans l'enceinte 2 en une seule opération.

Des échangeurs de chaleur 17 et/ou collecteurs 7 peuvent être reliés mécaniquement les uns aux autres uniquement par l'ensemble de conduites du circuit 8 de fluide de cycle.

L'invention n'est pas limitée aux exemples décrits ou illustrés comportant un ou deux plateaux. La forme des plateaux illustrée (circulaire) n'est pas limitative (toute autre forme, par exemple polygonale peut être envisagée).

Le dispositif 1 peut comporter plus de deux plateaux repartis selon une direction de répartition dans l'enceinte 2 et formant des étages thermiques. Ces plateaux peuvent être refroidis à des températures déterminées respectives, par exemple décroissantes dans la direction de répartition.

La [Fig. 11] illustre schématiquement une variante avec quatre collecteurs. Le premier collecteur 7 à l'extrémité inférieure reçoit un flux de fluide de cycle de la conduite 18 d'amenée et le distribue en parallèle à deux échangeurs 17 de chaleur via des conduites 18 de transfert. Ces deux échangeurs lui retournent ensuite le fluide via des conduites 38 de renvoi. Le premier collecteur 7 envoie ensuite ce flux de fluide de cycle vers un second collecteur 7 au-dessus via une conduite 148 de liaison. Le second collecteur 7 le distribue en parallèle à deux échangeurs 17 de chaleur via des conduites 18 de transfert. Ces deux échangeurs 17 lui retournent ensuite le fluide via des conduites 38 de renvoi. Le deuxième collecteur 7 envoie ensuite ce flux de fluide de cycle vers un troisième collecteur 7 au-dessus via une conduite 148 de liaison. Ce troisième collecteur 7 distribue ensuite le fluide en parallèle à deux échangeurs 17 de chaleur via des conduites 18 de transfert. Ces deux échangeurs 17 lui retournent ensuite le fluide via des conduites 38 de renvoi. Ce troisième collecteur renvoie le fluide de cycle vers le refroidisseur via une conduite 48 de retour. Le quatrième collecteur reçoit quant à lui un flux de fluide de cycle d'une autre conduite 18 d'amenée et le distribue en parallèle à deux échangeurs 17 de chaleur associés via des conduites 28 de transfert. Ces deux échangeurs 17 de chaleur lui retournent ensuite le fluide via des conduites 38 de renvoi. Ce quatrième collecteur 7 renvoie ensuite le fluide de cycle vers le refroidisseur via une autre conduite 48 de retour.

Les plateaux peuvent être espacés les uns des autres via des supports ou espaceurs, par exemple en matériau composite.

Au moins un des plateaux peut être relié à un écran thermique (ensemble de paroi(s)) formant un volume englobant au moins un plateau suivant. Le plateau et l'écran correspondant englobent les plateaux et écrans suivants selon une direction de répartition. C'est-à-dire que les plateaux et écrans peuvent être imbriqués à la façon de pièces « gigognes ».

En configuration de fonctionnement, le couvercle 3 peut être à température ambiante (au moins pour sa face extérieure) et les plateaux intérieurs dans l'enceinte 2 peuvent être refroidis à des températures décroissantes (par exemple respectivement à 90K, 50K, 10K et 3K dans le cas de quatre plateaux).

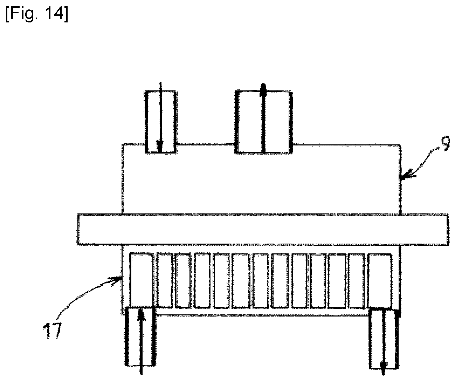

Comme illustré schématiquement à la [Fig. 14], au moins l'un des échangeurs 17 de chaleur décrits ci-dessus peut être utilisé pour échanger thermiquement avec un autre fluide de l'installation, par exemple pour refroidir cet autre fluide. Par exemple, l'échangeur de chaleur est mis en échange thermique, par exemple avec un autre échangeur 19 de chaleur recevant un flux de fluide plus chaud à refroidir, par exemple de l'He3 ou un mélange He3-He4. Comme illustré les deux échangeurs peuvent être accolés et/ou disposés de part et d'autre d'une plaque et/ou d'un plateau.

## Revendications

1. Dispositif de réfrigération cryogénique comprenant une enceinte (2) délimitant un volume étanche sous vide refermé par un couvercle (3), le dispositif (1) comprenant au moins un refroidisseur (4) cryogénique monté au travers du couvercle (3) et ayant une première portion située à l'extérieur de l'enceinte (2) et une seconde portion située dans l'enceinte (2), le refroidisseur (4) cryogénique étant du type adapté pour l'utilisation d'une source froide de fluide de cycle cryogénique tel que de l'hélium, le dispositif (1) comprenant au moins un plateau (5, 6) conducteur thermique destiné à recevoir et refroidir un composant, par exemple un ensemble de câble(s), un circuit (8) de fluide de cycle , un ensemble d'échangeur(s) de chaleur (17) et un collecteur (7), le au moins un plateau (5, 6) étant configuré pour être refroidi par un flux de fluide de cycle via le circuit (8) de fluide de cycle alimentant un ensemble d'échangeur(s) de chaleur (17) en échange thermique respectivement avec le plateau (5, 6), **caractérisé en ce que** le circuit (8) de fluide de cycle possède une conduite (18) d'amenée de fluide de cycle d'abord vers le collecteur (7) monté sur le plateau (5, 6), le circuit (8) de fluide de cycle possédant au moins une conduite (28) de transfert configurée pour transférer du fluide de cycle du collecteur (7) vers au moins un échangeur de chaleur (17) monté sur le même plateau (5), le circuit (8) de fluide de cycle possédant au moins une conduite (38) de renvoi configurée pour renvoyer du fluide ayant circulé dans le au moins un échangeur (17) de chaleur vers le collecteur (7).

2. Dispositif de réfrigération selon la revendication 1, **caractérisé en ce qu'**il comprend plusieurs échangeurs (17) de chaleur montés sur le même plateau (5, 6) et des conduites (28) de transfert respectives pour transférer du fluide de cycle du collecteur (7) vers les échangeurs de chaleur (17), les échangeurs de chaleur du même plateau (5) étant alimentés en fluide de cycle en parallèle à partir de la conduite (18) d'amenée via le collecteur (7).

3. Dispositif de réfrigération selon la revendication 1 ou 2, **caractérisé en ce que** la conduite (18) d'amenée de fluide traverse le couvercle (3) au niveau d'une plaque (9) support refermant de façon étanche un passage au travers du couvercle (3), la plaque (9) support, le collecteur (7) et la conduite (18) d'amenée étant reliés mécaniquement les uns aux autres en formant une entité physique qui peut être montée/démontée relativement à l'enceinte (2), par exemple relativement au couvercle (3).

4. Dispositif de réfrigération selon l'une quelconque des revendications 1 à 3, **caractérisé en ce que** le circuit (8) de fluide de cycle possède une conduite (48) de retour reliant le collecteur (7) à une partie du réfrigérateur et configurée pour renvoyer le fluide de cycle réchauffé ayant circulé dans tout ou partie de l'ensemble d'échangeur(s) de chaleur (7, 17).

5. Dispositif de réfrigération selon les revendications 3 et 4, **caractérisé en ce que** la conduite (48) de retour traverse le couvercle (3) au niveau de la plaque (9) support et également reliée à cette dernière et au collecteur (7).

6. Dispositif de réfrigération selon l'une quelconque des revendications 1 à 5, **caractérisé en ce que** le collecteur (7) est un échangeur de chaleur en échange thermique avec le plateau (5) et possède un circuit (70) interne de circulation du fluide de cycle en vue de transférer de la puissance froide au plateau (5).

7. Dispositif de réfrigération selon l'une quelconque des revendications 1 à 6, **caractérisé en ce que** le ou les échangeurs de chaleur (17) comprennent ou sont constitués de l'un au moins parmi : une plaque montée sur ou dans un logement du plateau (5, 6), la plaque possédant un circuit (70) interne de circulation du fluide de cycle en vue de transférer de la puissance froide au plateau (5), une conduite de circulation du fluide de cycle noyée et serpentant dans l'épaisseur du plateau (5, 6).

8. Dispositif de réfrigération selon l'une quelconque des revendications 1 à 7, **caractérisé en ce que** le ou les échangeurs de chaleur (17) sont reliés au collecteur (7) via un ensemble de raccords (171) fluidiques démontables, par exemple au moins au niveau d'une extrémité de la conduite (28) de transfert et/ou de la conduite (38) de renvoi.

9. Dispositif de réfrigération selon l'une quelconque des revendications 1 à 8, **caractérisé en ce qu'**il comporte plusieurs plateaux (5, 6) disposés selon une direction de répartition dans l'enceinte (2) et destinés à être refroidis à des températures respectives déterminées, au moins deux plateaux (5, 6) comportent chacun un collecteur (7) et au moins un échangeur de chaleur (17) reliée au collecteur (7) via une conduite (18) de transfert.

10. Dispositif de réfrigération selon la revendication 9, **caractérisé en ce que** les collecteurs (7) d'au moins deux plateaux (5, 6) distincts sont alimentés en fluide de cycle par des conduites (18) d'amenée respectives.

11. Dispositif de réfrigération selon la revendication 10, **caractérisé en ce que** le collecteur (7) d'un premier plateau (6) est alimenté en fluide de cycle par une conduite (18) d'amenée de fluide, le collecteur (7) et/ou le(s) échangeur(s) (17) de chaleur d'un second plateau (5) étant alimenté(s) en fluide de cycle ayant circulé dans au moins un échangeur et/ou collecteur du premier plateau (6) via un ensemble de conduite (148, 248) de liaison.

12. Dispositif de réfrigération selon l'une quelconque des revendications 1 à 11, **caractérisé en ce qu'**au moins une partie des échangeurs de chaleur (17) est muni d'au moins un parmi : un capteur (10) de température de l'échangeur, un organe (11) de chauffage configuré pour réguler la température de l'échangeur (17) de chaleur.

13. Dispositif de réfrigération selon l'une quelconque des revendications 1 à 12, **caractérisé en ce que** le circuit (8) de fluide de cycle comprend une ou plusieurs vanne(s) (13) pilotable(s), par exemple au niveau d'au moins une conduite (38) d'amenée de fluide et configurée(s) pour réguler le débit de fluide de cycle, par exemple en fonction d'une consigne et/ou d'une mesure d'un capteurs (10) de température.

14. Dispositif de réfrigération selon l'une quelconque des revendications 1 à 13, **caractérisé en ce qu'**au moins une partie des échangeurs de chaleur (17) et/ou collecteur (7) sont logés dans des logements respectifs correspondants formés dans les plateaux (5, 6) respectifs, une bordure périphérique des échangeurs de chaleur (17) et/ou collecteur (7) étant en contact avec une bordure conjuguée des échangeurs de chaleur (17) respectifs délimitant le logement.

15. Dispositif de réfrigération selon la revendication 14, **caractérisé en ce qu'**au moins une partie de l'ensemble d'échangeurs de chaleur (17) et/ou collecteur (7) sont montés dans les logements respectifs des plateaux en étant insérés dans lesdits logements avec déplacement transversal et/ou parallèle relativement au plans des plateaux (5, 6).

16. Procédé de réfrigération utilisant un dispositif selon l'une quelconque des revendications 1 à 15, comprenant une étape de stockage et/ou de production d'un fluide de cycle cryogénique liquide au niveau du réfrigérateur (4), une étape de mise en circulation dudit fluide cryogénique dans l'enceinte (2) vers le au moins un collecteur (7) et du collecteur (7) vers le au moins un échangeur de chaleur (17) pour refroidir au moins un plateau, le procédé comprenant une étape de retour du fluide de cycle réchauffé ayant circulé dans au moins un échangeur (17) de chaleur vers une portion du réfrigérateur (4) en vue de son refroidissement pour recommencer un cycle de circulation dans l'enceinte (2).

## Patentansprüche

1. Eine kryogene Kühleinrichtung, umfassend ein Gehäuse (2), das ein durch einen Deckel (3) verschlossenes, evakuiertes, dichtes Volumen begrenzt, wobei die Einrichtung (1) mindestens einen kryogenen Kühler (4) umfasst, der durch den Deckel (3) montiert ist und einen ersten Abschnitt außerhalb des Gehäuses (2) und einen zweiten Abschnitt innerhalb des Gehäuses (2) aufweist, wobei der kryogene Kühler (4) von dem Typ ist, der zur Verwendung einer kalten Quelle eines kryogenen Kreislauffluids, wie beispielsweise Helium, geeignet ist, wobei die Einrichtung (1) mindestens eine thermisch leitende Platte (5, 6) umfasst, die dazu bestimmt ist, eine Komponente, beispielsweise eine Kabelanordnung, aufzunehmen und zu kühlen, einen Fluidkreislauf (8), eine Baugruppe von Wärmetauscher(n) (17) und einen Sammler (7), wobei die mindestens eine Platte (5, 6) dazu konfiguriert ist, durch einen Fluss von Kreislauffluid über den Fluidkreislauf (8), der eine Baugruppe von Wärmetauscher(n) (17) jeweils in Wärmeaustausch mit der Platte (5, 6) speist, gekühlt zu werden, **dadurch gekennzeichnet, dass** der Fluidkreislauf (8) eine Zufuhrleitung (18) für Kreislauffluid besitzt, die zuerst zu dem auf der Platte (5, 6) montierten Sammler (7) führt, wobei der Fluidkreislauf (8) mindestens eine Transferleitung (28) besitzt, die dazu konfiguriert ist, Kreislauffluid von dem Sammler (7) zu mindestens einem Wärmetauscher (17) zu übertragen, der auf derselben Platte (5) montiert ist, wobei der Fluidkreislauf (8) mindestens eine Rückführleitung (38) besitzt, die dazu konfiguriert ist, Fluid, das in dem mindestens einen Wärmetauscher (17) zirkuliert hat, zu dem Sammler (7) zurückzuführen.

2. Die Kühleinrichtung nach Anspruch 1, **dadurch gekennzeichnet, dass** sie mehrere Wärmetauscher (17) umfasst, die auf derselben Platte (5, 6) montiert sind, und jeweilige Transferleitungen (28) zur Übertragung von Kreislauffluid von dem Sammler (7) zu den Wärmetauschern (17), wobei die Wärmetauscher derselben Platte (5) parallel von der Zufuhrleitung (18) über den Sammler (7) mit Kreislauffluid versorgt werden.

3. Die Kühleinrichtung nach Anspruch 1 oder 2, **dadurch gekennzeichnet, dass** die Fluidzufuhrleitung (18) den Deckel (3) auf Höhe einer Stützplatte (9) durchquert, die einen Durchgang durch den Deckel (3) dicht verschließt, wobei die Stützplatte (9), der Sammler (7) und die Zufuhrleitung (18) mechanisch miteinander verbunden sind und eine physische Einheit bilden, die relativ zu dem Gehäuse (2), zum Beispiel relativ zu dem Deckel (3), montiert/demontiert werden kann.

4. Die Kühleinrichtung nach einem der Ansprüche 1 bis 3, **dadurch gekennzeichnet, dass** der Fluidkreislauf (8) eine Rückführleitung (48) besitzt, die den Sammler (7) mit einem Teil des Kühlers verbindet und dazu konfiguriert ist, das erwärmte Kreislauffluid, das in der gesamten oder einem Teil der Wärmetauscherbaugruppe (7, 17) zirkuliert hat, zurückzuführen.

5. Die Kühleinrichtung nach den Ansprüchen 3 und 4, **dadurch gekennzeichnet, dass** die Rückführleitung (48) den Deckel (3) auf Höhe der Stützplatte (9) durchquert und ebenfalls mit dieser und dem Sammler (7) verbunden ist.

6. Die Kühleinrichtung nach einem der Ansprüche 1 bis 5,
**dadurch gekennzeichnet, dass** der Sammler (7) ein Wärmetauscher in thermischem Austausch mit der Platte (5) ist und einen internen Zirkulationskreislauf (70) des Kreislauffluids besitzt, um die Kälteleistung auf die Platte (5) zu übertragen.

7. Die Kühleinrichtung nach einem der Ansprüche 1 bis 6, **dadurch gekennzeichnet, dass** der oder die Wärmetauscher (17) mindestens eines der Folgenden umfassen oder daraus bestehen:
eine Platte, die auf oder in einer Aufnahme der Platte (5, 6) montiert ist, wobei die Platte einen internen Zirkulationskreislauf (70) des Kreislauffluids besitzt, um die Kälteleistung auf die Platte (5) zu übertragen, eine Zirkulationsleitung des Kreislauffluids, die in der Dicke der Platte (5, 6) eingebettet ist und sich darin windet.

8. Die Kühleinrichtung nach einem der Ansprüche 1 bis 7, **dadurch gekennzeichnet, dass** der oder die Wärmetauscher (17) über eine Baugruppe von demontierbaren Fluidanschlüssen (171) mit dem Sammler (7) verbunden sind, zum Beispiel mindestens auf Höhe eines Endes der Transferleitung (28) und/oder der Rückführleitung (38).

9. Die Kühleinrichtung nach einem der Ansprüche 1 bis 8, **dadurch gekennzeichnet, dass** sie mehrere Platten (5, 6) umfasst, die entlang einer Verteilungsrichtung in dem Gehäuse (2) angeordnet sind und dazu bestimmt sind, auf bestimmte jeweilige Temperaturen gekühlt zu werden, wobei mindestens zwei Platten (5, 6) jeweils einen Sammler (7) und mindestens einen Wärmetauscher (17) umfassen, der über eine Transferleitung (18) mit dem Sammler (7) verbunden ist.

10. Die Kühleinrichtung nach Anspruch 9, **dadurch gekennzeichnet, dass** die Sammler (7) von mindestens zwei unterschiedlichen Platten (5, 6) über jeweilige Zufuhrleitungen (18) mit Kreislauffluid versorgt werden.

11. Die Kühleinrichtung nach Anspruch 10, **dadurch gekennzeichnet, dass** der Sammler (7) einer ersten Platte (6) über eine Fluidzufuhrleitung (18) mit Kreislauffluid versorgt wird, wobei der Sammler (7) und/oder der/die Wärmetauscher (17) einer zweiten Platte (5) über eine Verbindungsleitung (148, 248) mit Kreislauffluid versorgt werden, das in mindestens einem Tauscher und/oder Sammler der ersten Platte (6) zirkuliert hat.

12. Die Kühleinrichtung nach einem der Ansprüche 1 bis 11, **dadurch gekennzeichnet, dass** mindestens ein Teil der Wärmetauscher (17) mit mindestens einem der folgenden Elemente ausgestattet ist: einem Sensor (10) für die Temperatur des Tauschers, einem Heizelement (11), das zur Regulierung der Temperatur des Wärmetauschers (17) konfiguriert ist.

13. Die Kühleinrichtung nach einem der Ansprüche 1 bis 12, **dadurch gekennzeichnet, dass** der Fluidkreislauf (8) ein oder mehrere steuerbare Ventil(e) (13) umfasst, zum Beispiel auf Höhe von mindestens einer Fluidzufuhrleitung (38) und dazu konfiguriert, den Durchfluss des Kreislauffluids zu regulieren, zum Beispiel in Abhängigkeit von einem Sollwert und/oder einer Messung eines Temperatursensors (10).

14. Die Kühleinrichtung nach einem der Ansprüche 1 bis 13, **dadurch gekennzeichnet, dass** mindestens ein Teil der Wärmetauscher (17) und/oder des Sammlers (7) in entsprechenden jeweiligen Aufnahmen untergebracht ist, die in den jeweiligen Platten (5, 6) ausgebildet sind, wobei eine Umfangsrandzone der Wärmetauscher (17) und/oder des Sammlers (7) in Kontakt mit einer konjugierten Randzone der jeweiligen Wärmetauscher (17) steht, die die Aufnahme begrenzt.

15. Die Kühleinrichtung nach Anspruch 14, **dadurch gekennzeichnet, dass** mindestens ein Teil der Baugruppe von Wärmetauschern (17) und/oder des Sammlers (7) in den jeweiligen Aufnahmen der Platten montiert ist, indem sie mit einer Quer- und/oder Parallelverschiebung relativ zu den Ebenen der Platten (5, 6) in die besagten Aufnahmen eingefügt werden.

16. Ein Kühlverfahren unter Verwendung einer Einrichtung nach einem der Ansprüche 1 bis 15, umfassend einen Schritt des Speicherns und/oder Erzeugens eines flüssigen kryogenen Kreislauffluids auf Höhe des Kühlers (4), einen Schritt des Inumlaufbringens des besagten kryogenen Fluids in dem Gehäuse (2) zu dem mindestens einen Sammler (7) und von dem Sammler (7) zu dem mindestens einen Wärmetauscher (17), um mindestens eine Platte zu kühlen, wobei das Verfahren einen Schritt des Zurückführens des erwärmten Kreislauffluids, das in mindestens einem Wärmetauscher (17) zirkuliert hat, zu einem Abschnitt des Kühlers (4) umfasst, um es erneut zu kühlen und einen Zirkulationszyklus in dem Gehäuse (2) neu zu starten.

## Claims

1. A cryogenic refrigeration device comprising an enclosure (2) delimiting a sealed vacuum volume closed by a cover (3), the device (1) comprising at least one cryogenic cooler (4) mounted through the cover (3) and having a first portion located outside the enclosure (2) and a second portion located inside the enclosure (2), the cryogenic cooler (4) being of the type adapted for using a cold source of cryogenic cycle fluid such as helium, the device (1) comprising at least one thermally conductive plate (5, 6) intended to receive and cool a component, for example a cable assembly, a fluid cycle circuit (8), a heat exchanger assembly (17) and a manifold (7), the at least one plate (5, 6) being configured to be cooled by a flow of cycle fluid via the fluid cycle circuit (8) feeding a heat exchanger assembly (17) in thermal exchange respectively with the plate (5, 6), **characterized in that** the fluid cycle circuit (8) comprises a fluid cycle supply line (18) directed first towards the manifold (7) mounted on the plate (5, 6), the fluid cycle circuit (8) comprising at least one transfer line (28) configured to transfer cycle fluid from the manifold (7) towards at least one heat exchanger (17) mounted on the same plate (5), the fluid cycle circuit (8) comprising at least one return line (38) configured to return the fluid that has circulated in the at least one heat exchanger (17) towards the manifold (7).

2. The refrigeration device according to claim 1, **characterized in that** it comprises several heat exchangers (17) mounted on the same plate (5, 6) and respective transfer lines (28) for transferring cycle fluid from the manifold (7) towards the heat exchangers (17), the heat exchangers of the same plate (5) being supplied with cycle fluid in parallel from the supply line (18) via the manifold (7).

3. The refrigeration device according to claim 1 or 2, **characterized in that** the fluid supply line (18) passes through the cover (3) at a support plate (9) sealingly closing a passage through the cover (3), the support plate (9), the manifold (7) and the supply line (18) being mechanically connected to each other forming a physical entity that can be mounted/dis-mounted relative to the enclosure (2), for example relative to the cover (3).

4. The refrigeration device according to any one of claims 1 to 3, **characterized in that** the fluid cycle circuit (8) comprises a return line (48) connecting the manifold (7) to a part of the cooler and configured to return the reheated cycle fluid having circulated in all or part of the heat exchanger assembly (7, 17).

5. The refrigeration device according to claims 3 and 4, **characterized in that** the return line (48) passes through the cover (3) at the support plate (9) and is also connected to the latter and to the manifold (7).

6. The refrigeration device according to any one of claims 1 to 5, **characterized in that** the manifold (7) is a heat exchanger in thermal exchange with the plate (5) and has an internal circulation circuit (70) for the cycle fluid for the purpose of transferring cold power to the plate (5).

7. The refrigeration device according to any one of claims 1 to 6, **characterized in that** the heat exchanger(s) (17) comprise or are constituted by at least one of: a plate mounted on or in a recess of the plate (5, 6), the plate having an internal circulation circuit (70) for the cycle fluid for the purpose of transferring cold power to the plate (5), a cycle fluid circulation line submerged and winding in the thickness of the plate (5, 6).

8. The refrigeration device according to any one of claims 1 to 7, **characterized in that** the heat exchanger(s) (17) are connected to the manifold (7) via an assembly of detachable fluid fittings (171), for example at least at one end of the transfer line (28) and/or of the return line (38).

9. The refrigeration device according to any one of claims 1 to 8, **characterized in that** it comprises several plates (5, 6) disposed along a distribution direction in the enclosure (2) and intended to be cooled at determined respective temperatures, at least two plates (5, 6) each comprising a manifold (7) and at least one heat exchanger (17) connected to the manifold (7) via a transfer line (18).

10. The refrigeration device according to claim 9, **characterized in that** the manifolds (7) of at least two distinct plates (5, 6) are supplied with cycle fluid by respective supply lines (18).

11. The refrigeration device according to claim 10,
**characterized in that** the manifold (7) of a first plate (6) is supplied with cycle fluid by a fluid supply line (18), the manifold (7) and/or the heat exchanger(s) (17) of a second plate (5) being supplied with cycle fluid having circulated in at least one exchanger and/or manifold of the first plate (6) via a connection line assembly (148, 248).

12. The refrigeration device according to any one of claims 1 to 11, **characterized in that** at least a part of the heat exchangers (17) is provided with at least one of: a sensor (10) for the temperature of the exchanger, a heating element (11) configured to regulate the temperature of the heat exchanger (17).

13. The refrigeration device according to any one of claims 1 to 12, **characterized in that** the fluid cycle circuit (8) comprises one or more controllable valve(s) (13), for example at the level of at least one fluid supply line (38) and configured to regulate the flow rate of the cycle fluid, for example based on a setpoint and/or a measurement from a temperature sensor (s) (10).

14. The refrigeration device according to any one of claims 1 to 13, **characterized in that** at least a part of the heat exchangers (17) and/or manifold (7) are housed in corresponding respective recesses formed in the respective plates (5, 6), a peripheral edge of the heat exchangers (17) and/or manifold (7) being in contact with a conjugated edge of the respective heat exchangers (17) delimiting the recess.

15. The refrigeration device according to claim 14, **characterized in that** at least a part of the heat exchanger assembly (17) and/or manifold (7) are mounted in the respective recesses of the plates by being inserted into said recesses with transversal and/or parallel displacement relative to the planes of the plates (5, 6).

16. A refrigeration method using a device according to any one of claims 1 to 15, comprising a step of storing and/or producing a liquid cryogenic cycle fluid at the cooler (4), a step of circulating said cryogenic fluid into the enclosure (2) towards the at least one manifold (7) and from the manifold (7) towards the at least one heat exchanger (17) to cool at least one plate, the method comprising a step of returning the reheated cycle fluid having circulated in at least one heat exchanger (17) towards a portion of the cooler (4) for the purpose of cooling it again to restart a circulation cycle in the enclosure (2).
